# EUROPEAN PATENT APPLICATION

(11) **EP 4 386 640 A1**
(43) Date of publication of application: **19.06.2024**
(21) Application number: 22212936.3
(22) Date of filing: 12.12.2022
(51) Int. Cl.: G06Q 10/06

(54) **A SYSTEM AND METHOD THEREIN FOR REDUCING THE ENVIRONMENTAL IMPACT OF A VEHICLE**

(71) Applicant: VOLVO TRUCK CORPORATION, 405 08 Göteborg (SE)
(72) Inventor: TALAMANTES PAVON, Jose, 434 52 Kungsbacka (SE); ESTRAGNAT, Emmanuel, 69110 STE FOY LES LYON (FR)
(74) Representative: Zacco Sweden AB

(57) **Abstract**

A system and method therein for reducing the environmental impact of a vehicle is described. It describes obtaining, from the vehicle, actual operation and performance data of the vehicle; obtaining, from a simulator, simulated operation and performance data for the vehicle, wherein the simulated operation and performance data is at least partly based on actual operation and performance data of multiple vehicles; determining that an environmental impact based on the actual operation and performance data obtained from the vehicle is reduced compared to an environmental impact based on the simulated operation and performance data obtained from the simulator; and providing information indicating a reduction in environmental impact of the actual operation and performance data from the vehicle to a digital crypto-assets generating system such that an amount of digital crypto-assets corresponding to said reduction is able to be generated. Computer program products and storage mediums are also described.

## Description

### TECHNICAL FIELD

The disclosure relates generally to environmental impact management. In particular aspects, the disclosure relates to a system and method therein for reducing the environmental impact of a vehicle. In further aspects, the disclosure also relates to computer program products for performing the method and storage mediums. Although the disclosure may be described with respect to a particular vehicle, the disclosure is not restricted to any particular vehicle.

### BACKGROUND

Environmental impact management for a vehicle may involve creating a series of plans and protocols aiming to manage and monitor the identified environmental mitigation measures that has been put in place for the vehicle. Such environmental impact management allows a company or organization to reduce its environmental impacts and increase its operating efficiency. While a lot of investments are being made within environmental impact management for these reasons, there are few ways in which a company or organization is able to take direct advantage of their investment in low-carbon emission solutions and/or carbon emission footprint. Such direct advantages would assist in increasing the amount of investment in environmental impact reducing practices and policies, such as, e.g. efficient driving, efficient transport solutions, etc. Hence, there is a need for improved environmental impact management.

### SUMMARY

According to a first aspect of the embodiments herein, a computer-implemented method performed by a system for reducing the environmental impact of a vehicle is described. The method comprise obtaining, from the vehicle, actual operation and performance data of the vehicle. The method also comprise obtaining, from a simulator, simulated operation and performance data for the vehicle, wherein the simulated operation and performance data is at least partly based on actual operation and performance data of multiple vehicles. Further, the method comprise determining that an environmental impact based on the actual operation and performance data obtained from the vehicle is reduced compared to an environmental impact based on the simulated operation and performance data obtained from the simulator. Furthermore, the method comprise providing information indicating a reduction in environmental impact of the actual operation and performance data from the vehicle to a digital crypto-assets generating system such that an amount of digital crypto-assets corresponding to said reduction is able to be generated.

The first aspect of the disclosure may seek to enable an environmental impact management that may reduce a vehicle's environmental impact. A technical benefit may include that by measuring and comparing the actual operation and performance data of a vehicle with simulated operation and performance data (e.g. operation and performance data simulated from a digital twin model for the vehicle that is based on a large amount of operation and performance data from a large number of similar vehicles), a fair and balanced average baseline may be obtained for determining whether or not the vehicle is actually improving its environmental footprints and reducing its emission. Hence, the amount by which the vehicle has improved versus the simulation may be used to create a digital crypto-asset and thus provide a direct and tangible advantage to the investments made by the vehicle's owner/operator in reducing the vehicle's environmental footprint. In other words, using a statistical/AI/ML model for the vehicle that is based on actual operation and performance data from multiple, similar vehicles as a baseline for determining a possible environmental impact reduction amount of the vehicle as described above, allows for an immediate and corresponding remuneration in the form of crypto-assets to a vehicle's owner/operator that has invested in reducing a vehicle's environmental footprint. This visualized and tangible impact of its environmental investments in the vehicle and/or driver of the vehicle allows the vehicle's owner/operator to easily detect and manage their fleet vehicle's environmental investments.

In some embodiments, the method may comprise obtaining information indicating operational maintenance activities executed for the vehicle. In this case, the method may also comprise determining a reduced environmental impact of the executed operational maintenance activities for the vehicle. The method may here also comprise providing information indicating the reduced environmental impact of the executed operational maintenance activities for the vehicle to a digital crypto-assets generating system such that an amount of digital crypto-assets corresponding to said reduced environmental impact is able to be generated. Here, a technical benefit may include an increased likelihood of having the vehicle's owner/operator performing maintenance operations, or vehicle part updates, which improves the vehicle's environmental footprint.

In some embodiments, the actual operation and performance data of the multiple vehicles used as a basis for the simulated operation and performance data for the vehicle by the simulator may be obtained for corresponding vehicle driving situation and conditions indicated by the actual operation and performance data of the vehicle, wherein the vehicle driving situation and conditions are based on one or more of: the vehicle's geographical positions, external operating temperatures of the vehicles, experienced traffic patterns of the vehicles, or determined route selections of the vehicles. In this case, a technical benefit may be that the comparison between the actual operation and performance data of the vehicle with the simulated actual operation and performance data may be based on corresponding parameters. For example, the simulated operation and performance data may be based on operation and performance data from multiple vehicles experiencing similar operating conditions, similar traffic environments and similar situations as the vehicle, which makes the comparison adaptive and customizable to a particular vehicle.

According to some embodiments, the information indicating the reduction in environmental impact of the actual operation and performance data from the vehicle, and/or the information indicating the reduced environmental impact of the executed operational maintenance activities for the vehicle, to a digital crypto-assets generating system may further comprise information identifying an entity to which the vehicle is related such that the generated amount of digital crypto-assets corresponding to said reduced environmental impact is able to be transferred by the digital crypto-assets generating system to a digital crypto-asset storage associated with an entity to which the vehicle is related. Here, a technical benefit may include that generated digital crypto-assets, such as, e.g. a crypto-currency or other transferable or tradable digital equity, may be transferred to an entity to which the vehicle is related, e.g. the vehicle's owner/operator, in a fast and efficient manner.

In some embodiments, the environmental impact may be represented by a carbon-dioxide, CO₂, or carbon-dioxide equivalent, CO₂e, indicator or emissions value. A technical benefit may include that a well-defined and commonly relatable measurement of the environmental impact may be established and assigned.

According to a second aspect of the embodiments herein, a system for reducing environmental impact of a vehicle is described. The system comprises a processing circuitry and a memory. The processing circuitry is configured to obtain, from the vehicle, actual operation and performance data of the vehicle. The processing circuitry is also configured to obtain, from a simulator, simulated operation and performance data for the vehicle, wherein the simulated operation and performance data is at least partly based on actual operation and performance data of multiple vehicles. Further, the processing circuitry is configured to determine that an environmental impact based on the actual operation and performance data obtained from the vehicle is reduced compared to an environmental impact based on the simulated operation and performance data obtained from the simulator. Also, the processing circuitry is configured to provide information indicating a reduction in environmental impact of the actual operation and performance data from the vehicle to a digital crypto-assets generating system such that an amount of digital crypto-assets corresponding to said reduction is able to be generated.

In some embodiments, the processing circuitry may further be configured to obtain information indicating operational maintenance activities executed for the vehicle, determine a reduced environmental impact of the executed operational maintenance activities for the vehicle, and provide information indicating the reduced environmental impact of the executed operational maintenance activities for the vehicle to a digital crypto-assets generating system such that an amount of digital crypto-assets corresponding to said reduced environmental impact is able to be generated.

In some embodiments, the actual operation and performance data of the multiple vehicles used as a basis for the simulated operation and performance data for the vehicle by the simulator may be obtained for corresponding vehicle driving situation and conditions indicated by the actual operation and performance data of the vehicle, wherein the vehicle driving situation and conditions are based on one or more of: the vehicle's geographical positions, external operating temperatures of the vehicles, experienced traffic patterns of the vehicles, or determined route selections of the vehicles.

According to some embodiments, the information indicating the reduction in environmental impact of the actual operation and performance data from the vehicle, and/or the information indicating the reduced environmental impact of the executed operational maintenance activities for the vehicle, to a digital crypto-assets generating system may further comprise information identifying an entity to which the vehicle is related such that the generated amount of digital crypto-assets corresponding to said reduced environmental impact is able to be transferred by the digital crypto-assets generating system to a digital crypto-asset storage associated with an entity to which the vehicle is related.

In some embodiments, the environmental impact may be represented by a carbon-dioxide, CO₂, or carbon-dioxide equivalent, CO₂e, indicator or emissions value.

Effects and advantages of this second aspect is to a large extent analogous to those described above in connection with the first aspect

According to a third aspect of the embodiments herein, a computer program product comprising program code means for performing the steps of the methods described above when said program is run on a processing circuitry of a network system or a processing circuitry of a user device, respectively, is described. According to a fourth aspect of the embodiments herein, a non-transitory computer-readable storage medium comprising instructions, which when executed on a processing circuitry of a network system or on a processing circuitry of a user device, cause the processing circuitry to perform the methods described above is described. Effects and advantages of the third and fourth aspects are to a large extent analogous to those described above in connection with the first and second aspect.

The above aspects, accompanying claims, and/or embodiments disclosed herein above and later below may be suitably combined with each other as would be apparent to anyone of ordinary skill in the art.

Additional features and advantages are disclosed in the following description, claims, and drawings, and in part will be readily apparent therefrom to those skilled in the art or recognized by practicing the disclosure as described herein. There are also disclosed herein control units, computer readable media, and computer program products associated with the above discussed technical benefits.

### BRIEF DESCRIPTION OF THE DRAWINGS

Features and advantages of the embodiments will become readily apparent to those skilled in the art by the following detailed description of exemplary embodiments thereof with reference to the accompanying drawings, wherein:
**FIG. 1** is a schematic illustration of communications network in which a system configured to reduce the environmental impact of a vehicle according to some embodiments may be implemented,
**FIG. 2** is a flowchart depicting embodiments of a method for reducing environmental impact of a vehicle according to some embodiments,
**FIG. 3** is a schematic block diagram depicting embodiments of a system, and
**FIG. 4** is a schematic diagram of an exemplary computer system for implementing embodiments disclosed herein according to some embodiments.

### DETAILED DESCRIPTION

Aspects set forth below represent the necessary information to enable those skilled in the art to practice the disclosure.

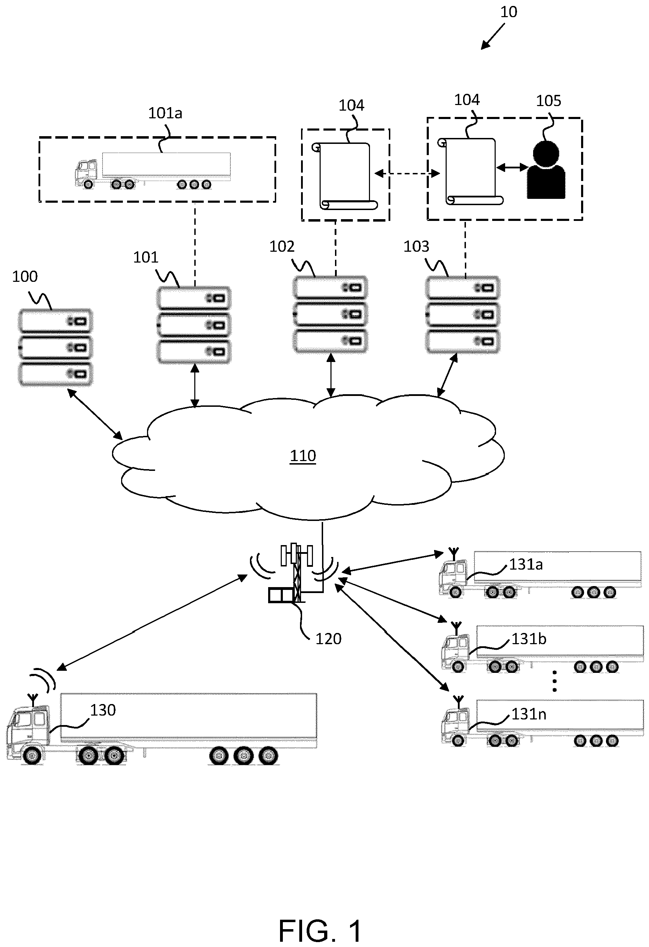

**FIG. 1** illustrates an example of a **communication system 10** in which a **system 100** for reducing the environmental impact of a vehicle 130 according to embodiments described herein may be implemented. Besides the system 100, the communication system 10 may comprise and connect the system 100 with a **simulator 101,** a **digital crypto-asset generating system 102,** and a **digital crypto-asset storage 103.** The simulator 101 may be a vehicle simulation system arranged to create a **simulation 101a** for a vehicle, e.g. a so-called digital model or digital twin model for the vehicle 130, at least partly based on actual operation and performance data P_{A} provided from multiple vehicles, e.g. the multiple number of vehicles 131a, 131b, ..., 131n described below. The simulation 101a may, for example, be a statistical and/or Artificial Intelligence/Machine Learning, AI/ML, driven virtual model or replica of the same type of vehicle that the vehicle 130 is. Here, it should also be noted that a digital twin may be a digital representation of a physical or real object or process. Thus, in the context of the embodiments herein, the digital twin 30 may be configured based on historic data from a vehicle fleet, e.g. the multiple number of vehicles 131a, 131b, ..., 131n, for the vehicle 130. In this case, the digital twin 30 may also be described as an average of the vehicles in the vehicle fleet, possibly optimized. Thus, the digital twin may represent an ideal vehicle, for example, in terms of fuel consumption, driving behavior, etc.

The digital crypto-asset generating system 102 may here be a system configured to create or generate **digital crypto-assets 104,** e.g. an amount of crypto-currency, based on instructions and information provided by the system 100. The digital crypto-asset storage 103 is a digital storage system for storing the digital crypto-assets 104, e.g. an e-wallet or similar, generated by the digital crypto-asset generating system 102 and associating the stored digital crypto-assets 104 with an **entity 105,** e.g. an entity to which the vehicle 130 is related, such as, the vehicle's owner/operator. Here, it should be noted that one or more of the system 100, the simulator 101, the digital crypto-asset generating system 102, and the digital crypto-asset storage 103, may be implemented by one or more centrally located and/or distributed network units, such as, e.g. online data processing server(s). Optionally, one or more of the system 100, the simulator 101, the digital crypto-asset generating system 102, and the digital crypto-asset storage 103 may also form part of a cloud service in the communications network 110, e.g. the Internet. It should also be noted that the simulator 101, the digital crypto-asset generating system 102, and the digital crypto-asset storage 103 may also be co-located and/or form part of the system 100.

According to one example, as shown FIG. 1, the communications system 10 may comprise a **vehicle 130** and a **multiple number of vehicles 131a, 131b,** ..., **131n.** In some embodiments, the vehicle 130 and each of the multiple number of vehicles 131a, 131b, ..., 131n may be identical or similar types of vehicles. The vehicle 130 and each of the multiple number of vehicles 131a, 131b, ..., 131n may comprise wireless communications enabled devices that allows the vehicle 130 and each of the multiple number of vehicles 131a, 131b, ..., 131n, respectively, to wirelessly communicate with the communications network 110 via one or more **access points and/or radio base stations 120.** Thus, the vehicle 130 and each of the multiple number of vehicles 131a, 131b, ..., 131n are able to provide actual operation and performance data P_{A}, respectively, to the system 100 and/or the simulator 101.

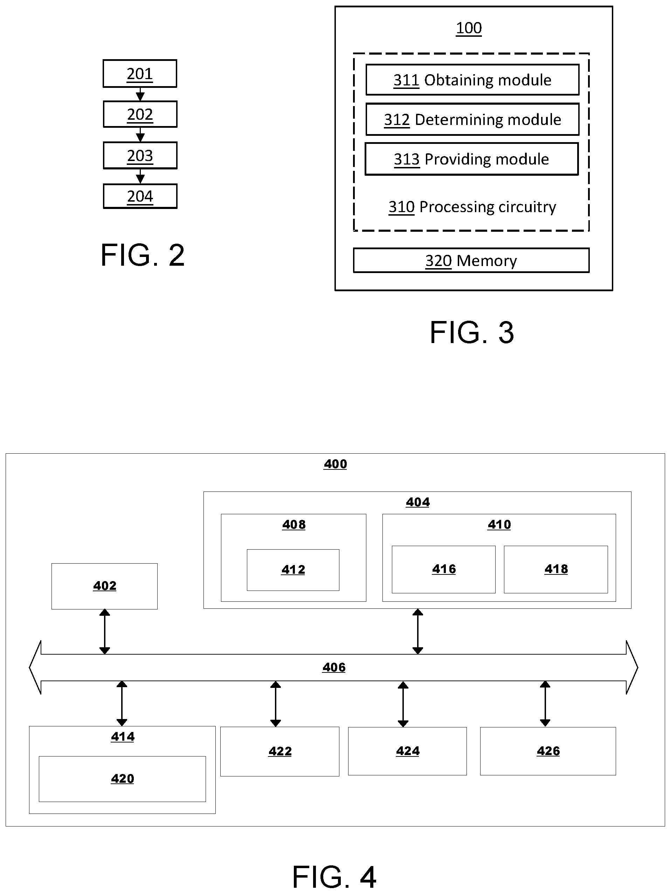

Embodiments of a computer-implemented method performed by a system 100 for reducing the environmental impact of a vehicle 130, will now be described with reference to the flowchart depicted in **FIG. 2.** FIG. 2 is an illustrated example of actions, steps or operations which may be performed by the system 100 described above with reference to FIG. 1. The method may comprise the following actions, steps or operations.

**Action 201.** The system 100 obtains, from the vehicle 130, actual operation and performance data P_{A} of the vehicle 130. This means, for example, that the system 100 may obtain real and actual operation and performance data from the vehicle 130 that indicates the current operation and performance of the vehicle 130, as well as, the current performance of the driver of the vehicle 130. This operation and performance data may comprise a high number of different vehicle parameters, driving characteristics, environmental factors, etc. Here, the vehicle parameters may comprise, for example, speed, the load of the vehicle, fuel consumption, engine condition and performance factors, brake performance, vehicle sensor data, tachometer information, etc. The driving characteristics or metrics may, for example, comprise route selection, telematics information relating to the driver's operation of the vehicle and behavior, etc. Environmental factors may, for example, comprise information indicating the current temperature, current weather conditions, route, route length and terrain, etc.

Optionally, in some embodiments, the system 100 may further obtain information indicating operational maintenance activities executed for the vehicle 130. This means, for example, that the system 100 may retrieve or receive information, e.g. from the vehicle 130 directly or another separate vehicle maintenance system (not shown), indicating which operational maintenance activities that has been performed on the vehicle 130. Optionally, the system 100 may retrieve or receive this information from the simulator 101, since the simulator 101 and the simulation of the vehicle 130 may comprise information regarding the operational maintenance activities of the vehicle 130, such as, service history, configuration changes, parts replacement and warranty data of the vehicle 130.

**Action 202.** The system 100 also obtains, from a simulator 101, simulated operation and performance data Ps for the vehicle 130. Here, the simulated operation and performance data Ps is at least partly based on actual operation and performance data P_{A} of multiple vehicles 131a, 131b, ..., 131n. This means, for example, that a simulator 101 may create a simulation for the vehicle 130, e.g. a digital model or digital twin model for the vehicle 130, based on the actual operation and performance data P_{A} provided from multiple vehicles, e.g. the multiple number of vehicles 131a, 131b, ..., 131n shown in FIG. 1. Here, the parameters of the actual operation and performance data P_{A} provided from multiple vehicles 131a, 131b, ..., 131n may be identical or similar to the parameters of the actual operation and performance data P_{A} provided from the vehicle 130 as indicated in Action 201. The actual operation and performance data P_{A} provided from the multiple number of vehicles 131a, 131b, ..., 131n may be obtained over an extended period of time in order to build up large enough amount of information to ensure that a suitable simulation model for the vehicle 130 may be created by the simulator 101. The simulation model, or digital twin model, for the vehicle 130 may then be run or processed by the simulator 101 simultaneously as the vehicle 130 operates, and thus generate and provide simulated operation and performance data Ps for the vehicle 130. This simulated operation and performance data P_{S} for the vehicle 130 may then be obtained by the system 100 on-demand or continuously. One example of the simulated operation and performance data Ps for the vehicle 130 may be a simulated energy consumption of the digital twin model for the vehicle 130.

In some embodiments, the actual operation and performance data P_{A} of the multiple vehicles 131a, 131b, ..., 131n used as a basis for the simulated operation and performance data P_{S} for the vehicle 130 by the simulator 101 are obtained for corresponding vehicle driving situation and conditions indicated by the actual operation and performance data P_{A} of the vehicle 130, wherein the vehicle driving situation and conditions are based on one or more of: the vehicle's geographical positions, external operating temperatures of the vehicles, experienced traffic patterns of the vehicles, or determined route selections of the vehicles. This means, for example, that the system 100 may obtain simulated operations and performance data Ps for the vehicle 130 that is based on actual operation and performance data P_{A} from multiple vehicles 131a, 131b, ..., 131n that has been operated under similar vehicle driving situation and conditions. This may, for example, advantageously improve the suitability of the simulated operations and performance data Ps for the vehicle 130 to be used in the determination according to Action 203 below, hence also improving the accuracy of the determination in Action 203. For example, the selection of the multiple vehicles 131a, 131b, ..., 131n for which actual operation and performance data P_{A} is to be considered in the simulation for the vehicle 130 may be based on identical or similar vehicles operating within the same or similar geographical areas, temperatures, traffic situations, routes, etc. In other words, the vehicles in the vehicle fleet having similar mission and configurations may, for example, be selected and considered in the simulation for the vehicle 130 to improve the correlation with the vehicle 130.

**Action 203.** After obtaining the actual operation and performance data P_{A} of the vehicle 130 and the simulated operation and performance data Ps for the vehicle 130 in Actions 201-202, the system 100 determines that an environmental impact E_{A} based on the actual operation and performance data P_{A} obtained from the vehicle 130 is reduced compared to an environmental impact Es based on the simulated operation and performance data Ps obtained from the simulator 101. This means, for example, that the system 100 may use the actual operation and performance data P_{A} obtained from the vehicle 130 to determine an environmental impact E_{A} of the vehicle 130. Similarly, the system 100 may use the simulated operation and performance data P_{A} obtained from the simulator 101 to determine an environmental impact Es for the vehicle 130. In a simple example, for instance, the system 100 may take all or some of the actual operation and performance data P_{A} obtained from the vehicle 130, e.g. the current fuel consumption, to determine the current carbon-emissions of the vehicle 130, e.g. a current CO2-value. In this case, the system 100 may also take all or some of the simulated operation and performance data P_{A} obtained from the simulator 101, e.g. a simulated fuel consumption, to determine a simulated carbon-emissions of the vehicle 130, e.g. a simulated CO2-value. After comparing the environmental impact E_{A} with the environmental impact Es, the system 100 may conclude that the environmental impact E_{A} is lower than the environmental impact Es, i.e. E_{A} < Es. For example, the current CO2-value of the vehicle 130 is lower than the simulated CO2-value. In this case, the system 100 may proceed to action 204. If, however, the system 100 may conclude that the environmental impact E_{A} is equal to or higher than the environmental impact E_{S}, e.g. E_{A} ≥ E_{S}, the system 100 may not proceed any further.

Optionally, in case information indicating operational maintenance activities executed for the vehicle 130 was obtained in Action 201, the system 100 may further determine a reduced environmental impact E_{MAIN} based on the executed operational maintenance activities for the vehicle 130. This means, for example, that the system 100 may assign determined amount of reduced environmental impact E_{MAIN} for each executed operational maintenance activities for the vehicle 130. For example, exchanging an existing cab wing or spoiler of a truck with a more effective version or solution may be assigned a certain determined amount of reduced environmental impact E_{MAIN}. However, it should also be noted that certain activities, such as, not performing operational maintenance or service of the vehicle 130 according to a planned service schedule, may assign an increased environmental impact E_{MAIN} for the vehicle 130. Other operational maintenance activities may, for example, comprise adding a specific aerodynamic device on the vehicle 130, uploading an environmentally focused software update (eco-software) in the vehicle 130, selecting the most energy efficient tires, performing a driver training of the driver of the vehicle 130.

**Action 204.** After determining that there is a reduction in the environmental impact of the vehicle 130 as compared to the simulation for the vehicle 130 in Action 203, the system 100 provide information indicating the reduction in environmental impact, E_{DIFF} = E_{S}-E_{A}, of the actual operation and performance data P_{A} from the vehicle 130 to a digital crypto-assets generating system 102 such that an amount of digital crypto-assets 104 corresponding to said reduction is able to be generated. This means, for example, that the system 100 may transmit information to the digital crypto-assets generating system 102, as shown in FIG.1, indicating the reduction in environmental impact that the vehicle 130 has achieved. Thereby, the digital crypto-assets generating system 102 is able to generate an amount of digital crypto-assets 104, e.g. a proprietary or public crypto-currency, corresponding to the indicated achieved reduction in environmental impact of the vehicle 130. Hence, a direct and tangible digital asset creation may be made that correspondingly reflect the environmental investments made by the owner/operator of the vehicle 130 has made in the vehicle 130 and/or the driver of the vehicle 130.

Optionally, in case a reduced environmental impact E_{MAIN} based on the executed operational maintenance activities for the vehicle 130 was obtained in Action 203, the system 100 may further provide information indicating the reduced environmental impact E_{MAIN} of the executed operational maintenance activities for the vehicle 130 to a digital crypto-assets generating system 102 such that an amount of digital crypto-assets 104 corresponding to said reduced environmental impact E_{MAIN} is able to be generated. This means, for example, that the system 100 may transmit information to the digital crypto-assets generating system 102, as shown in FIG.1, indicating the reduction in environmental impact that the vehicle 130 has achieved due to executed operational maintenance activities. Thereby, the digital crypto-assets generating system 102 is able to generate an amount of digital crypto-assets 104, e.g. a proprietary or public crypto-currency, corresponding to the reduction in environmental impact that the vehicle 130 has achieved due to executed operational maintenance activities. Hence, a direct and tangible digital asset creation may be made that correspondingly reflect the environmental investments made by the owner/operator of the vehicle 130 has made in the operational maintenance of the vehicle 130 that improves its environmental impact.

In some embodiments, the information indicating the reduction in environmental impact E_{DIFF} of the actual operation and performance data P_{A} from the vehicle 130, and/or the information indicating the reduced environmental impact E_{MAIN} of the executed operational maintenance activities for the vehicle 130, to a digital crypto-assets generating system 102 further comprise information identifying an entity 105 to which the vehicle 130 is related such that the generated amount of digital crypto-assets 104 corresponding to said reduced environmental impact E_{DIFF}, E_{MAIN} is able to be transferred by the digital crypto-assets generating system 102 to a digital crypto-asset storage 103 associated with an entity 105 to which the vehicle 130 is related. This means, for example, that the system 100 may transfer the generated digital crypto-assets, such as, e.g. a crypto-currency or other transferable or tradable digital equity, to an entity 105 to which the vehicle 130 is related, e.g. the vehicle's owner/operator, in a fast and efficient manner, e.g. to an e-wallet of the vehicle's owner/operator configured to store the digital crypto-assets.

In some embodiments, the environmental impact E_{A}, Es, E_{DIFF}, E_{MAIN} is represented by a carbon-dioxide, CO₂, or carbon-dioxide equivalent, CO₂e, indicator or emissions value. This means, for example, that the system 100 may established and assigned a well-defined and commonly relatable measurement of the environmental impact E_{A}, E_{S}, E_{DIFF}, E_{MAIN}.

To perform the method actions in a system 100 for reducing environmental impact of a vehicle 130, the system 100 may comprise the following arrangement depicted in **FIG 3.** FIG 3 shows a schematic block diagram of embodiments of the system 100. The embodiments of the system 100 described herein may be considered as independent examples, or may be considered in any combination with each other to describe nonlimiting examples. It should also be noted that, although not shown in FIG. 3, it should be noted that known conventional features of a system 100, such as, for example, a connection to the mains, network connections (e.g. input/output ports, etc.), etc., may be assumed to be comprised in the system 100 but is not shown or described any further in regards to FIG. 3. The system 100 may comprise one or more centrally located or distributed network unit(s), wherein the system 100 and the one or more network unit(s) may comprise **processing circuitry 310** and a **memory 320.** It should also be noted that some or all of the functionality described in the examples above as being performed by the system 100 may be provided by the processing circuitry 310 executing instructions stored on a computer-readable medium, such as, the memory 320 shown in FIG. 3. The processing circuitry 310 may also comprise an **obtaining module 311,** a **determining module 312,** and a **providing module 313,** each responsible for providing its functionality to support the examples described herein.

The system 100 or processing circuitry 310 is configured to, or may comprise the obtaining module 311 configured to, obtain, from the vehicle 130, actual operation and performance data P_{A} of the vehicle 130. Also, the system 100 or processing circuitry 310 is also configured to, or may comprise the obtaining module 311 configured to, obtain simulated operation and performance data Ps for the vehicle 130, wherein the simulated operation and performance data P_{S} is at least partly based on operation and performance data of multiple vehicles 131a, 131b, ..., 131n. Further, the system 100 or processing circuitry 310 is configured to, or may comprise the determining module 312 configured to, determine that an environmental impact E_{A} based on the actual operation and performance data P_{A} obtained from the vehicle 130 is reduced compared to an environmental impact Es based on the simulated operation and performance data Ps obtained from the simulator 101. Furthermore, the system 100 or processing circuitry 310 is configured to, or may comprise the providing module 313 configured to, provide information indicating a reduction in environmental impact E_{DIFF} of the actual operation and performance data P_{A} from the vehicle 130 to a digital crypto-assets generating system 102 such that an amount of digital crypto-assets 104 corresponding to said reduction is able to be generated.

In some embodiments, the system 100 or processing circuitry 310 may be configured to, or may comprise the obtaining module 313 configured to, obtain, from the vehicle 130, information indicating operational maintenance activities executed for the vehicle 130. In this case, the system 100 or processing circuitry 310 may also be configured to, or may comprise the determining module 312 configured to, determine a reduced environmental impact E_{MAIN} of the executed operational maintenance activities for the vehicle 130. Furthermore, the system 100 or processing circuitry 310 may here also be configured to, or may comprise the providing module 313 configured to, provide indicating the reduced environmental impact E_{MAIN} of the executed operational maintenance activities for the vehicle 130 to a digital crypto-assets generating system 102 such that an amount of digital crypto-assets 104 corresponding to said reduced environmental impact E_{MAIN} is able to be generated.

According to some embodiments, the actual operation and performance data P_{A} of the multiple vehicles 131a, 131b, ..., 131n used as a basis for the simulated operation and performance data P_{S} for the vehicle 130 by the simulator 101 may be obtained for corresponding vehicle driving situation and conditions. Here, the vehicle driving situation and conditions may be based on one or more of: the vehicle's geographical positions, external operating temperatures of the vehicles, experienced traffic patterns of the vehicles, or determined route selections of the vehicles. In some embodiments, the information indicating the reduction in environmental impact E_{DIFF} of the actual operation and performance data P_{A} from the vehicle 130, and/or the information indicating the reduced environmental impact E_{MAIN} of the executed operational maintenance activities of the vehicle 130, to a digital crypto-assets generating system 102 may further comprise information identifying an entity 105 to which the vehicle 130 is related such that the generated amount of digital crypto-assets 104 corresponding to said reduced environmental impact E_{MAIN}, E_{DIFF} is able to be transferred by the digital crypto-assets generating system 102 to a digital crypto-asset storage 103 associated with an entity 105 to which the vehicle 130 is related. In some embodiments, the environmental impact E_{A}, Es, E_{DIFF}, E_{MAIN} is represented by a carbon-dioxide, CO₂, or carbon-dioxide equivalent, CO₂e, indicator or emissions value.

Furthermore, the embodiments for reducing environmental impact of a vehicle 130 described above may be implemented through one or more processors, such as the processing circuitry 310 in the system 100 depicted in FIG. 3, together with computer program code for performing the functions and actions of the examples herein. The program code mentioned above may also be provided as a computer program product, for instance in the form of a data carrier carrying computer program code or code means for performing the examples herein when being loaded into the processing circuitry 310 in the system 100. The computer program code may e.g. be provided as pure program code in the network system 100 or on a server and downloaded to the system 100. Thus, it should be noted that the modules of the system 100 may in some examples be implemented as computer programs stored in memory, e.g. in the memory modules 320 in FIG. 3, for execution by processors or processing modules, e.g. the processing circuitry 310 of FIG. 3. Those skilled in the art will also appreciate that the processing circuitry 310 and the memory 320 described above may refer to a combination of analog and digital circuits, and/or one or more processors configured with software and/or firmware, e.g. stored in a memory, that when executed by the one or more processors such as the processing circuitry 310 perform as described above. One or more of these processors, as well as the other digital hardware, may be included in a single application-specific integrated circuit (ASIC), or several processors and various digital hardware may be distributed among several separate components, whether individually packaged or assembled into a system-on-a-chip (SoC).

**FIG. 4** is a schematic diagram of a computer system **400** for implementing examples disclosed herein. The computer system **400** is adapted to execute instructions from a computer-readable medium to perform these and/or any of the functions or processing described herein. The computer system **400** may be connected (e.g., networked) to other machines in a LAN, an intranet, an extranet, or the Internet. While only a single device is illustrated, the computer system **400** may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system **400** may comprise at least one computing device or electronic device capable of including firmware, hardware, and/or executing software instructions to implement the functionality described herein. The computer system **400** may include a processor device **402** (may also be referred to as a control unit), a memory **404,** and a system bus **406.** The computer system **400** may include at least one computing device having the processor device **402.** The system bus **406** provides an interface for system components including, but not limited to, the memory **404** and the processor device **402.** The processor device **402** may include any number of hardware components for conducting data or signal processing or for executing computer code stored in memory **404.** The processor device **402** (e.g., control unit) may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logc, discrete hardware components, or any combination thereof designed to perform the functions described herein. The processor device may further include computer executable code that controls operation of the programmable device.

The system bus **406** may be any of several types of bus structures that may further interconnect to a memory bus (with or without a memory controller), a peripheral bus, and/or a local bus using any of a variety of bus architectures. The memory **404** may be one or more devices for storing data and/or computer code for completing or facilitating methods described herein. The memory **404** may include database components, object code components, script components, or other types of information structure for supporting the various activities herein. Any distributed or local memory device may be utilized with the systems and methods of this description. The memory **404** may be communicably connected to the processor device **402** (e.g., via a circuit or any other wired, wireless, or network connection) and may include computer code for executing one or more processes described herein. The memory **404** may include non-volatile memory **405** (e.g., read-only memory (ROM), erasable programmable read-only memory (EPROM), electrically erasable programmable read-only memory (EEPROM), etc.), and volatile memory **410** (e.g., random-access memory (RAM)), or any other medium which can be used to carry or store desired program code in the form of machine-executable instructions or data structures and which can be accessed by a computer or other machine with a processor device **402.** A basic input/output system (BIOS) **412** may be stored in the non-volatile memory **405** and can include the basic routines that help to transfer information between elements within the computer system **400.**

The computer system **400** may further include or be coupled to a non-transitory computer-readable storage medium such as the storage device **414,** which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device **414** and other drives associated with computer-readable media and computer-usable media may provide non-volatile storage of data, data structures, computer-executable instructions, and the like.

A number of modules can be implemented as software and/or hard-coded in circuitry to implement the functionality described herein in whole or in part. The modules may be stored in the storage device **414** and/or in the volatile memory **410,** which may include an operating system **416** and/or one or more program modules **415.** All or a portion of the examples disclosed herein may be implemented as a computer program product **420** stored on a transitory or non-transitory computer-usable or computer-readable storage medium (e.g., single medium or multiple media), such as the storage device **414,** which includes complex programming instructions (e.g., complex computer-readable program code) to cause the processor device **402** to carry out the steps described herein. Thus, the computer-readable program code can comprise software instructions for implementing the functionality of the examples described herein when executed by the processor device **402.** The processor device **402** may serve as a controller or control system for the computer system **400** that is to implement the functionality described herein.

The computer system **400** also may include an input device interface **422** (e.g., input device interface and/or output device interface). The input device interface **422** may be configured to receive input and selections to be communicated to the computer system **400** when executing instructions, such as from a keyboard, mouse, touch-sensitive surface, etc. Such input devices may be connected to the processor device **402** through the input device interface **422** coupled to the system bus **406** but can be connected through other interfaces such as a parallel port, an Institute of Electrical and Electronic Engineers (IEEE) 1394 serial port, a Universal Serial Bus (USB) port, an IR interface, and the like. The computer system **400** may include an output device interface **424** configured to forward output, such as to a display, a video display unit (e.g., a liquid crystal display (LCD) or a cathode ray tube (CRT)). The computer system **400** may also include a communications interface **426** suitable for communicating with a network as appropriate or desired.

The operational steps described in any of the exemplary aspects herein are described to provide examples and discussion. The steps may be performed by hardware components, may be embodied in machine-executable instructions to cause a processor to perform the steps, or may be performed by a combination of hardware and software. Although a specific order of method steps may be shown or described, the order of the steps may differ. In addition, two or more steps may be performed concurrently or with partial concurrence.

According to some additional examples, a control system comprising one or more control units configured to perform the method according to any of the examples described above is also provided.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the inventive concepts being set forth in the following claims.

## Claims

1. A computer-implemented method performed by a system (100) for reducing the environmental impact of a vehicle (130), the method comprising:
*obtaining* (201), from the vehicle (130), actual operation and performance data (P_{A}) of the vehicle (130);
*obtaining* (202), from a simulator (101), simulated operation and performance data (Ps) for the vehicle (130), wherein the simulated operation and performance data (P_{S}) is at least partly based on actual operation and performance data (P_{A}) of multiple vehicles (131a, 131b, ..., 131n);
*determining* (203) that an environmental impact (E_{A}) based on the actual operation and performance data (P_{A}) obtained from the vehicle (130) is reduced compared to an environmental impact (Es) based on the simulated operation and performance data (Ps) obtained from the simulator (101); and
*providing* (204) information indicating a reduction in environmental impact (E_{DIFF}) of the actual operation and performance data (P_{A}) from the vehicle (130) to a digital crypto-assets generating system (102) such that an amount of digital crypto-assets (104) corresponding to said reduction is able to be generated.

2. The computer-implemented method according to claim 1, wherein the *obtaining* (201) further comprise obtaining information indicating operational maintenance activities executed for the vehicle (130), the *determining* (203) further comprise determining a reduced environmental impact (E_{MAIN}) of the executed operational maintenance activities for the vehicle (130), and the *providing* (204) further comprise providing information indicating the reduced environmental impact (E_{MAIN}) of the executed operational maintenance activities for the vehicle (130) to a digital crypto-assets generating system (102) such that an amount of digital crypto-assets (104) corresponding to said reduced environmental impact (E_{MAIN}) is able to be generated.

3. The computer-implemented method according to claim 1 or 2, wherein the actual operation and performance data (P_{A}) of the multiple vehicles (131a, 131b, ..., 131n) used as a basis for the simulated operation and performance data (Ps) for the vehicle (130) by the simulator (101) are obtained for corresponding vehicle driving situation and conditions indicated by the actual operation and performance data P_{A} of the vehicle 130, wherein the vehicle driving situation and conditions are based on one or more of: the vehicle's geographical positions, external operating temperatures of the vehicles, experienced traffic patterns of the vehicles, or determined route selections of the vehicles.

4. The computer-implemented method according to any of claims 1-3, wherein the information indicating the reduction in environmental impact (E_{DIFF}) of the actual operation and performance data (P_{A}) of the vehicle (130), and/or the information indicating the reduced environmental impact (E_{MAIN}) of the executed operational maintenance activities for the vehicle (130), to a digital crypto-assets generating system (102) further comprise information identifying an entity (105) to which the vehicle (130) is related such that the generated amount of digital crypto-assets (104) corresponding to said reduced environmental impact (E_{MAIN;} E_{DIFF}) is able to be transferred by the digital crypto-assets generating system (102) to a digital crypto-asset storage (103) associated with an entity (105) to which the vehicle (130) is related.

5. The computer-implemented method according to any of claims 1-4, wherein the environmental impact (E_{A}, E_{S}, E_{DIFF}, E_{MAIN}) is represented by a carbon-dioxide, CO₂, or carbon-dioxide equivalent, CO₂e, indicator or emissions value.

6. A system (100) for reducing environmental impact of a vehicle (130), the system (100) comprising a processing circuitry (310) and a memory (320), the processing circuitry (310) being configured to:
obtain, from the vehicle (130), actual operation and performance data (P_{A}) of the vehicle (130), obtain, from a simulator (101), simulated operation and performance data (Ps) for the vehicle (130), wherein the simulated operation and performance data (P_{S}) is at least partly based on actual operation and performance data (P_{A}) of multiple vehicles (131a, 131b, ..., 131n), determine that an environmental impact (E_{A}) based on the actual operation and performance data (P_{A}) obtained from the vehicle (130) is reduced compared to an environmental impact (Es) based on the simulated operation and performance data (Ps) obtained from the simulator (101), and provide information indicating a reduction in environmental impact (E_{DIFF}) of the actual operation and performance data (P_{A}) from the vehicle (130) to a digital crypto-assets generating system (102) such that an amount of digital crypto-assets (104) corresponding to said reduction is able to be generated.

7. The system (100) according to claim 6, wherein the processing circuitry (310) is further configured to obtain information indicating operational maintenance activities executed for the vehicle (130), determine a reduced environmental impact (E_{MAIN}) of the executed operational maintenance activities for the vehicle (130), and provide information indicating the reduced environmental impact (E_{MAIN}) of the executed operational maintenance activities for the vehicle (130) to a digital crypto-assets generating system (102) such that an amount of digital crypto-assets (104) corresponding to said reduced environmental impact (E_{MAIN}) is able to be generated.

8. The system (100) according to claim 6 or 7, wherein the actual operation and performance data (P_{A}) of the multiple vehicles (131a, 131b, ..., 131n) used as a basis for the simulated operation and performance data (Ps) for the vehicle (130) by the simulator (101) are obtained for corresponding vehicle driving situation and conditions indicated by the actual operation and performance data P_{A} of the vehicle 130, wherein the vehicle driving situation and conditions are based on one or more of: the vehicle's geographical positions, external operating temperatures of the vehicles, experienced traffic patterns of the vehicles, or determined route selections of the vehicles.

9. The system (100) according to any of claims 6-8, wherein the information indicating the reduction in environmental impact (E_{DIFF}) of the actual operation and performance data (P_{A}) of the vehicle (130), and/or the information indicating the reduced environmental impact (E_{MAIN}) of the executed operational maintenance activities for the vehicle (130), to a digital crypto-assets generating system (102) further comprise information identifying an entity (105) to which the vehicle (130) is related such that the generated amount of digital crypto-assets (104) corresponding to said reduced environmental impact (E_{MAIN;} E_{DIFF}) is able to be transferred by the digital crypto-assets generating system (102) to a digital crypto-asset storage (103) associated with an entity (105) to which the vehicle (130) is related.

10. The system (100) according to any of claims 6-9, wherein the environmental impact (E_{A}, E_{S}, E_{DIFF}, E_{MAIN}) is represented by a carbon-dioxide, CO₂, or carbon-dioxide equivalent, CO₂e, indicator or emissions value.

11. A computer program product comprising program code for performing the method according to any of claims 1-5 when said program is run on a processing circuitry (310).

12. A non-transitory computer-readable storage medium comprising instructions, which when executed on a processing circuitry (310), cause the processing circuitry (310) to perform the method of any of claims 1-5.
